# EUROPEAN PATENT APPLICATION

(11) **EP 4 694 596 A1**
(43) Date of publication of application: **11.02.2026**
(21) Application number: 24208585.0
(22) Date of filing: 24.10.2024
(51) Int. Cl.: H05K 7/20, G06F 1/20

(54) **HEAT DISSIPATION SYSTEM**

(30) Priority: 08.08.2024 TW 113129647
(71) Applicant: Newcrea Technology Co., Ltd., Hsinchu City 300 (TW)
(72) Inventor: Tung, Chao-Nien, 300 Hsinchu City (TW); Huang, Lung-Wei, 300 Hsinchu City (TW)
(74) Representative: Straus, Alexander

(57) **Abstract**

A heat dissipation system (1, 1', 1", 1‴) includes a housing (10), an electronic device (12), an atomizer (14) and a vacuum pump (16). The electronic device (12) is disposed in the housing (10). The electronic device (12) includes a heat source (120). The atomizer (14) is disposed relative to the electronic device (12). The atomizer (14) is configured to atomize and spray a working fluid (28) to the heat source (120). The vacuum pump (16) is connected to the housing (10). The vacuum pump (16) is configured to vacuumize the housing (10). The heat dissipation system (1, 1', 1", 1‴) can effectively improve the heat dissipation effect through the cooperation of vacuuming and atomization mechanisms.

## Description

### Field of the Invention

The present invention relates to a heat dissipation system, particularly a heat dissipation system capable of effectively improving the heat dissipation effect.

### Background of the Invention

Servers are used to serve various computers or portable electronic devices in network systems. As the performance of servers continues to improve, the system power consumption of servers is also getting higher and higher. How to effectively dissipate heat from a server rack has become a significant design issue.

### Summary of the Invention

The present invention aims at providing a heat dissipation system capable of effectively improving the heat dissipation effect, thereby resolving the aforesaid problems.

This is achieved by a heat dissipation system according to claim 1. The dependent claims pertain to corresponding further developments and improvements.

As will be seen more clearly from the detailed description following below, the claimed heat dissipation system includes a housing, an electronic device, an atomizer and a vacuum pump. The electronic device is disposed in the housing. The electronic device includes a heat source. The atomizer is disposed relative to the electronic device. The atomizer is configured to atomize and spray a working fluid to the heat source. The vacuum pump is connected to the housing. The vacuum pump is configured to vacuumize the housing.

### Brief Description of the Drawings

In the following, the invention is further illustrated by way of example, taking reference to the accompanying drawings thereof:
FIG. 1 is a schematic view illustrating a heat dissipation system according to an embodiment of the invention,
FIG. 2 is a schematic view illustrating a heat dissipation system according to another embodiment of the invention,
FIG. 3 is a schematic view illustrating a heat dissipation system according to another embodiment of the invention, and
FIG. 4 is a schematic view illustrating a heat dissipation system according to another embodiment of the invention.

### Detailed Description

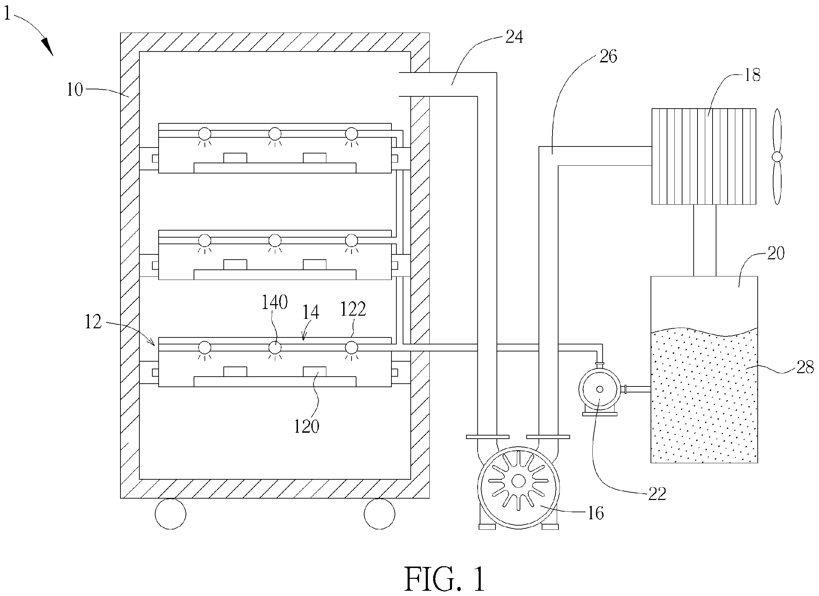

Referring to FIG. 1, FIG. 1 is a schematic view illustrating a heat dissipation system 1 according to an embodiment of the invention.

As shown in FIG. 1, the heat dissipation system 1 comprises a housing 10, an electronic device 12, an atomizer 14, a vacuum pump 16, a condenser 18, a liquid storage tank 20 and a pressurization pump 22. The housing 10 may be, but is not limited to, a server rack and the electronic device 12 may be, but is not limited to, a server or a switch. In practical applications, the housing 10 may be any base used to install the electronic device 12, and the electronic device 12 may be any electronic device with heat dissipation requirement.

The electronic device 12 and the atomizer 14 are disposed in the housing 10, and the atomizer 14 is disposed relative to the electronic device 12. In this embodiment, the electronic device 12 comprises a heat source 120 and a casing 122, wherein the heat source 120 and the atomizer 14 are disposed in the casing 122, and the atomizer 14 is located above the heat source 120. In this embodiment, the atomizer 14 may comprise a plurality of nozzles 140, wherein the plurality of nozzles 140 are spaced apart relative to the heat source 120.

It should be noted that the number of electronic device 12 and atomizer 14 may be one or more according to practical applications, so the invention is not limited to the embodiment shown in the figure. Furthermore, the number of heat source 120 and nozzle 140 may also be one or more according to practical applications, so the invention is not limited to the embodiment shown in the figure. The heat source 120 may be a chip or other heat generating components according to practical applications.

The vacuum pump 16 is connected to the housing 10. In this embodiment, the vacuum pump 16 is connected between the housing 10 and the condenser 18. The vacuum pump 16 may be connected to the housing 10 through a pipeline 24 and connected to the condenser 18 through another pipeline 26. The liquid storage tank 20 is connected to the condenser 18. The liquid storage tank 20 is configured to store a working fluid 28. The working fluid 28 may be water, oil or insulating liquid according to practical applications. The pressurization pump 22 is connected between the liquid storage tank 20 and the atomizer 14. The atomizer 14 is configured to atomize and spray the working fluid 28 to the heat source 120, so as to dissipate heat from the heat source 120. The vacuum pump 16 is configured to vacuumize the housing 10.

Before operating the heat dissipation system 1 of the invention, the housing 10 needs to be sealed and insulated to prevent air leakage or electric leakage. If necessary, a helium leak detector may also be used to check the degree of vacuum leakage inside the housing 10 to ensure the sealing and insulation inside the housing 10 before operation. Then, the vacuum pump 16 is turned on to remove the air and water vapor inside the housing 10 until the predetermined vacuum degree is reached. In this embodiment, a vacuum degree in the housing 10 may be between 1 torr and 760 torr according to practical heat dissipation requirement. Then, the atomizer 14 is started, such that the nozzles 140 begin to atomize and spray the working fluid 28 to the heat source 120. Then, the power of the electronic device 12 is turned on, such that the heat source 120 of the electronic device 12 starts to operate and generate heat. Since the heat source 120 has been sprayed with fine mist in advance, as long as the mist absorbs heat, it will change from liquid phase to vaporization. At this time, the vacuum degree within the housing 10 will determine the operating temperature of the environment where the electronic device 12 is located.

At this operating temperature, the heated and vaporized vapor will flow to the top of the housing 10 and then be transported to the vacuum pump 16 through the pipeline 24 on the top of the housing 10. Then, the vapor is transported to the condenser 18 through the pipeline 26. When the vapor passes through the condenser 18, the heat of the vapor will be released, such that the vapor is condensed back into liquid and flow into the liquid storage tank 20. The working fluid 28 is then transported to the nozzles 140 of the atomizer 14 through the pressurization pump 22 to regenerate mist. Accordingly, the working fluid 28 may be recycled repeatedly to achieve the purpose of energy saving and carbon reduction.

When the heat generated by the heat source 120 is higher, the total weight of the working fluid 28 that needs to be atomized and sprayed is greater. Thus, the minimum weight of working fluid 28 that needs to be atomized may be estimated based on the total wattage of heat generated by the heat source 120. Since the atomized working fluid 28 may not completely absorb latent heat and vaporize into gas, the actual consumed weight of the sprayed working fluid 28 must be greater than the estimated weight of the working fluid 28. In practice, the purposes of cooling and heat dissipation for different wattages of heat may be achieved by adding a plurality of nozzles 140 or increasing the atomization weight of the working fluid 28 of each nozzle 140.

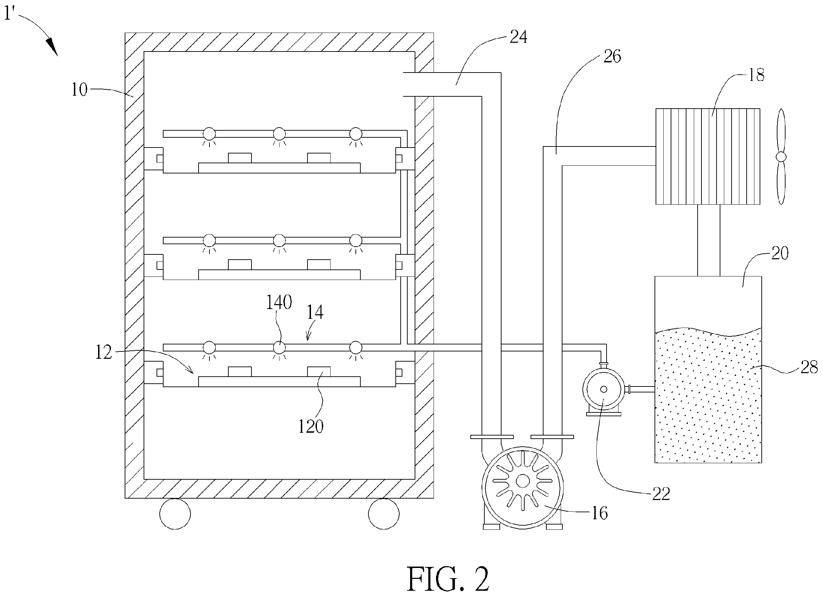

Referring to FIG. 2, FIG. 2 is a schematic view illustrating a heat dissipation system 1' according to another embodiment of the invention.

The main difference between the heat dissipation system 1' and the aforesaid heat dissipation system 1 is that the heat dissipation system 1' omits the casing 122 of the electronic device 12. As shown in FIG. 2, the atomizer 14 is disposed above the heat source 120. Thus, the nozzles 140 of the atomizer 14 can directly spray fine droplets onto the exposed heat source 120, such that it can greatly reduce the resistance of the vacuum pump 16 when absorbing vapor, and can take the heat absorbed by the vapor in the housing 10 away from the housing 10 more quickly, so as to achieve the purpose of rapid heat dissipation.

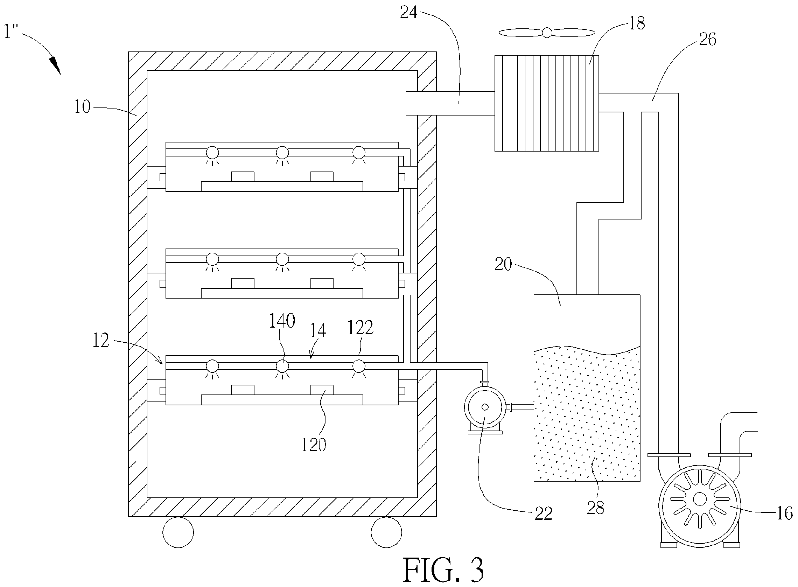

Referring to FIG. 3, FIG. 3 is a schematic view illustrating a heat dissipation system 1" according to another embodiment of the invention.

The main difference between the heat dissipation system 1" and the aforesaid heat dissipation system 1 is that the condenser 18 of the heat dissipation system 1" is connected between the housing 10 and the vacuum pump 16, as shown in FIG. 3. In this embodiment, the condenser 18 may be connected to the housing 10 through a pipeline 24 and connected to the vacuum pump 16 through another pipeline 26. Thus, the vapor that has absorbed heat and vaporized in the housing 10 will first pass through the condenser 18. At this time, most of the vapor may be condensed into liquid working fluid 28. The liquid working fluid 28 is first collected in the liquid storage tank 20 and then transported to the nozzles 140 of the atomizer 14 through the pressurization pump 22 to regenerate mist. The remaining vapor is extracted by the vacuum pump 16 and then discharged. This manner can greatly reduce the amount of vapor that the vacuum pump 16 has to process. Otherwise, all the vapor must pass through the vacuum pump 16 before being processed, which will inevitably require an extremely large vacuum pump 16 and will increase a lot of manufacturing costs.

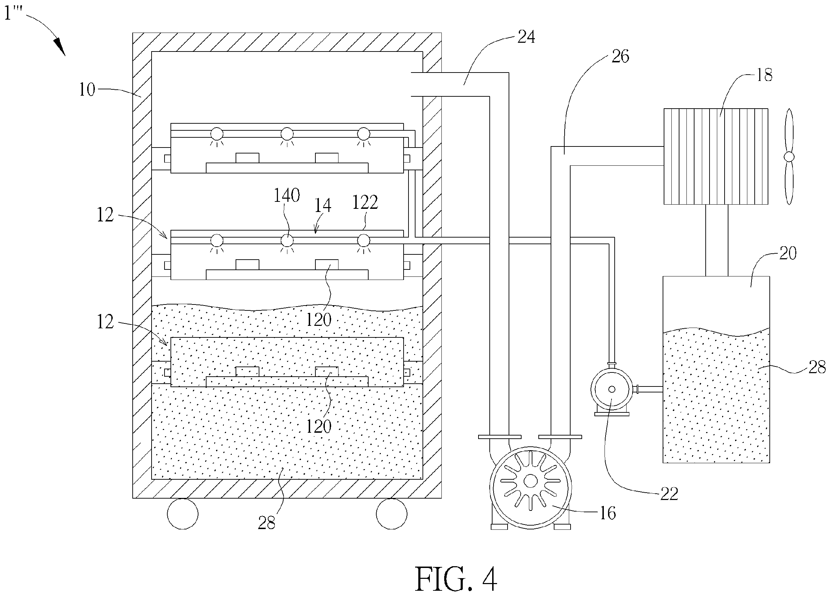

Referring to FIG. 4, FIG. 4 is a schematic view illustrating a heat dissipation system 1‴ according to another embodiment of the invention.

The main difference between the heat dissipation system 1‴ and the aforesaid heat dissipation system 1 is that the housing 10 of the heat dissipation system 1‴ is partially filled with the working fluid 28 in advance, such that one or more electronic devices 12 will be immersed in the liquid working fluid 28. The heat of the heat source 120 of other electronic devices 12 that are not immersed in the liquid working fluid 28 will still be dissipated by the vacuuming and atomization mechanisms as in the above embodiment. In order to maintain a stable liquid level in the housing 10, the liquid working fluid 28 may be replenished into the housing 10 in a timely manner, or it may be decided as needed whether to allow the heat-absorbing liquid working fluid 28 under the liquid level to leave the housing 10. This embodiment combines the mechanisms of vacuuming and atomization, and also adopts the heat dissipation advantages of two-phase immersion cooling. Since there is a vacuum above the liquid working fluid 28, the boiling point of the working fluid 28 will be lowered, such that the working fluid 28 under the liquid level is easier to absorb heat from the heat source 120, boil a large amount, and then turn into a gas to take away the heat, so as to achieve more effective and rapid cooling and heat dissipation.

The aforesaid embodiments may be applied to server racks in a data center, but the invention is not so limited. The same concept may also be extended to the application of other electronic products with space limitation and highly concentrated heat generation.

The heat dissipation system of the invention may be applied in an environment where space is limited and rapid heat dissipation is required. When a large amount of sprayed fine mist is used to absorb heat and generate a phase change, it will absorb a large amount of latent heat and vaporize into vapor at the same time. Thus, it can quickly absorb a large amount of heat from the surface of the heat source to achieve the purpose of quickly dissipating heat from the heat source.

Furthermore, the heat dissipation system may provide an environment with stable and constant temperature. When the fine mist generates a phase change and becomes vapor, it changes from the liquid phase to the gas phase, and the temperature of the phase change will remain at a constant value. Thus, it is possible to provide electronic devices (e.g. servers in a data center) to operate in a stable operating environment.

By absorbing heat through the mist, the nozzle of the atomizer can accurately control the size of the mist and the liquid weight of the sprayed mist. Thus, it may be suitable for applications with different wattages of heat generated by the heat source and is extremely flexible. Smaller mist will evaporate more easily, thereby increasing heat transfer efficiency. Furthermore, according to different heat sources, the invention may atomize and spray a large amount of appropriate working fluid on a heat source through the nozzle of the atomizer in a short period of time, so as to achieve the purpose of rapid and effective heat dissipation. Thus, according to different heat dissipation requirements, the invention may increase or decrease the weight of the sprayed working fluid, increase or decrease the number of nozzles of the atomizer, or adjust the spraying position. Accordingly, the heat dissipation system of the invention is extremely flexible.

Still further, the invention may control the working fluid to have different phase change temperatures under different vacuum degrees, such that there is diversity in choice of working fluids. The invention may choose working fluids that are safe and do not generate toxic gases or are not harmful to the environment, so as to protect the environment, save energy and reduce carbon emissions. In addition, the applied working fluid may be circulated, cooled and reused, thereby saving heat dissipation and manufacturing costs while avoiding waste and avoiding the generation of waste materials.

Moreover, the invention may spray more working fluid to the high-heat area and spray less working fluid to the low-heat area according to practical heat dissipation requirement. Thus, the heat dissipation system of the invention may satisfy diversified industries with different heat dissipation requirements according to the heat generating conditions of various heat sources.

As mentioned in the above, the invention utilizes the vacuum pump to vacuumize the housing and utilizes the atomizer to atomize and spray the working fluid to the heat source. In a vacuum environment, the temperature of the phase transition point of the working fluid will decrease. When the fine mist is heated, it will directly absorb heat and evaporate into vapor. The heated and vaporized vapor will flow upward. Then, the vaporized vapor will be quickly taken away from the housing through the vacuum pump, and then transported to the condenser. The heat of the vapor is released through heat exchange, such that the vapor is condensed back into liquid for repeated recycling. Since a large amount of fine mist will absorb a large amount of latent heat and vaporize into vapor during phase change, it can quickly absorb a large amount of heat from the surface of the heat source. Therefore, the invention can effectively improve the heat dissipation effect through the cooperation of vacuuming and atomization mechanisms.

## Claims

1. A heat dissipation system (1, 1', 1", 1‴) comprising:
a housing (10);
an electronic device (12) disposed in the housing (10), the electronic device (12) comprising a heat source (120);
**characterized by** the heat dissipation system (1, 1', 1", 1‴) further comprising:
an atomizer (14) disposed relative to the electronic device (12), the atomizer (14) being configured to atomize and spray a working fluid (28) to the heat source (120); and
a vacuum pump (16) connected to the housing (10), the vacuum pump (16) being configured to vacuumize the housing (10).

2. The heat dissipation system (1, 1', 1‴) of claim 1 further **characterized in that** the heat dissipation system (1, 1', 1‴) further comprises a condenser (18), and the vacuum pump (16) is connected between the housing (10) and the condenser (18).

3. The heat dissipation system (1") of claim 1 further **characterized in that** the heat dissipation system (1") further comprises a condenser (18), and the condenser (18) is connected between the housing (10) and the vacuum pump (16).

4. The heat dissipation system (1, 1', 1", 1‴) of claims 2 or 3 further **characterized in that** the heat dissipation system (1, 1', 1", 1‴) further comprises a liquid storage tank (20) connected to the condenser (18).

5. The heat dissipation system (1, 1", 1‴) of claim 1 further **characterized in that** the electronic device (12) comprises a casing (122), and the heat source (120) and the atomizer (14) are disposed in the casing (122).

6. The heat dissipation system (1, 1', 1", 1‴) of any of the preceding claims further **characterized in that** the atomizer (14) is disposed above the heat source (120).

7. The heat dissipation system (1, 1', 1", 1‴) of any of the preceding claims further **characterized in that** the heat dissipation system (1, 1', 1", 1‴) further comprises a pressurization pump (22) connected between the liquid storage tank (20) and the atomizer (14).

8. The heat dissipation system (1, 1', 1", 1‴) of any of the preceding claims further **characterized in that** a vacuum degree in the housing (10) is between 1 torr and 760 torr.

9. The heat dissipation system (1, 1', 1", 1‴) of any of the preceding claims further **characterized in that** the atomizer (14) comprises a plurality of nozzles (140), and the plurality of nozzles (140) are spaced apart relative to the heat source (120).

10. The heat dissipation system (1, 1', 1", 1‴) of any of the preceding claims further **characterized in that** the working fluid (28) is water, oil or insulating liquid.

## Amended claims

### Amended claims in accordance with Rule 137(2) EPC.

1. A heat dissipation system (1") comprising:
a housing (10);
an electronic device (12) disposed in the housing (10), the electronic device (12) comprising a heat source (120);
an atomizer (14) disposed relative to the electronic device (12), the atomizer (14) being configured to atomize and spray a working fluid (28) to the heat source (120);
**characterized by** the heat dissipation system (1") further comprising:
a vacuum pump (16) connected to the housing (10), the vacuum pump (16) being configured to vacuumize the housing (10) to reduce pressure inside the housing (10) to between 133.322 Pa (1 torr) and 101324.72 Pa (760 torr);
a condenser (18) connected between the housing (10) and the vacuum pump (16), the condenser (18) being configured to condense vapor of the working fluid (28) prior to the vapor entering the vacuum pump (16).

2. The heat dissipation system (1") of claim 1 further **characterized in that** the heat dissipation system (1") further comprises a liquid storage tank (20) connected to the condenser (18) and configured to collect the condensed working fluid (28).

3. The heat dissipation system (1") of claim 1 further **characterized in that** the electronic device (12) comprises a casing (122), and the heat source (120) and the atomizer (14) are disposed in the casing (122).

4. The heat dissipation system (1") of any of the preceding claims further **characterized in that** the atomizer (14) is disposed above the heat source (120).

5. The heat dissipation system (1") of any of the preceding claims further **characterized in that** the heat dissipation system (1") further comprises a pressurization pump (22) connected between the liquid storage tank (20) and the atomizer (14).

6. The heat dissipation system (1") of any of the preceding claims further **characterized in that** the atomizer (14) comprises a plurality of nozzles (140), and the plurality of nozzles (140) are spaced apart relative to the heat source (120).

7. The heat dissipation system (1") of any of the preceding claims further **characterized in that** the working fluid (28) is water, oil or insulating liquid.

8. The heat dissipation system (1") of any of the preceding claims further **characterized in that** the vacuum pump (16) is capable of continuously adjusting the pressure inside the housing (10) in real time based on temperature of the heat source (120).

9. The heat dissipation system (1") of any of the preceding claims further **characterized in that** the heat dissipation system (1") is used in high heat-density environments including servers, data centers, or power storage equipment.

10. The heat dissipation system (1") of any of the preceding claims further **characterized in that** the condenser (18) is a fin-type or coil-type heat exchanger.
